# EUROPEAN PATENT SPECIFICATION

(11) **EP 1 215 739 B1**
(45) Date of publication and mention of the grant of the patent: **07.03.2007**
(21) Application number: 01129617.5
(22) Date of filing: 12.12.2001
(51) Int. Cl.: H01L 51/30

(54) **Organic electroluminescent device**
Organische Leuchtdiode
Dispositif organique électroluminescent

(30) Priority: 12.12.2000 KR 2000075636
(43) Date of publication of application: 19.06.2002
(73) Proprietor: LG ELECTRONICS INC., Seoul (KR)
(72) Inventor: Oh, Hyoung Yun, Dongjak-gu, Seoul (KR); Seo, Jeong Dae, Daegukwangyok-shi (KR)
(74) Representative: Heinze, Ekkehard

(56) References cited:
- WO-A-00/03565
- ROBINSON M R ET AL: "ELECTROLUMINESCENCE FROM WELL-DEFINED TETRAHEDRAL OLIGOPHENYLENEVINYLENE TETRAMERS" ADVANCED MATERIALS, VCH VERLAGSGESELLSCHAFT, WEINHEIM, DE, vol. 12, no. 22, 16 November 2000 (2000-11-16), pages 1701-1704, XP000976722 ISSN: 0935-9648

## Description

### BACKGROUND OF THE INVENTION

### Field of the Invention

The present invention relates to an organic electroluminescent device, and more particularly, to an organic electroluminescent device in which a blue luminescent material of an organic luminescent layer is a compound of a tetraphenylmetane structure.

### Discussion of the Related Art

Recently, in accordance with the trend of a large-sized display device, a flat panel display device occupying a small area is being requested. As an example of the flat panel display device, an organic electroluminescent device called an organic light emitting diode (OLED) is rapidly developing.

The organic electroluminescent device emits light in such a manner that excitons generated in pairs by combining electrons with electron holes are removed with transiting from an excited state to a base state if the electrons and the electron holes are injected into an organic electroluminescent layer formed between a first electrode (anode) which is a hole injection electrode and a second electrode (cathode) which is an electron injection electrode.

Such an organic electroluminescent device can be driven at a lower voltage (for example, 10V or less) than that of a plasma display panel (PDP) or an inorganic electroluminescent device. In this respect, research of the organic electroluminescent device is actively in progress.

Characteristics of the organic electroluminescent device include a wide viewing angle, high speed response time, and high contrast. Accordingly, the organic electroluminescent device can be used as a pixel of a graphic display, television video display, or surface light source. The organic electroluminescent device may also be formed on a flexible transparent substrate such as plastic. Further, the organic electroluminescent device can be used for an advanced flat panel display (FPD) due to its thin, lightweight and good color characteristics. Moreover, since the organic electroluminescent device does not require a backlight unlike a well-known liquid crystal display (LCD), low power consumption is required. Accordingly, it has lately attracted considerable attention as a full color display device.

The aforementioned organic electroluminescent device can display three colors such as green, blue, and red. To this end, a luminescent device that emits light of three colors such as green, red, and blue is required to display full color.

A method for manufacturing a typical organic electroluminescent device will now be described.

First, an anode material such as indium tin oxide (ITO) is formed on a transparent substrate. A hole injection layer (HIL) is then formed on the anode material at a thickness of 10nm to 30nm. Copper phthalocyanine (CuPC) is mainly used as the hole injection layer.

Subsequently, a hole transport layer (HTL) is formed on the hole injection layer at a thickness of 30nm to 60nm. 4,4'-bis[N-(1-naphthyl)-N-phenylamino]-biphenyl (NPD) is used as the hole transport layer.

An organic luminescent layer is formed on the hole transport layer. At this time, a dopant is added to the organic luminescent layer as occasion demands. For example, in case of emitting a green color, the organic luminescent layer of Alq₃(tris(8-hydroxy-quinolate)aluminum) is deposited at a thickness of 30nm to 60nm, and N-Methylquinacridone(MQD) is used as a dopant.

Afterwards, the electron transport layer and the electron injection layer are sequentially formed on the organic luminescent layer. An electron injection/transport layer may be formed as the case may be. In case of emitting a green color, since Alq₃ used as the organic luminescent layer has excellent electron transport capability, the electron injection/transport layer may not be formed.

Next, a cathode is formed on the electron injection layer.

Finally, a passivation layer is formed, so that the organic electroluminescent device is completed.

In the manufactured organic electroluminescent device, a blue color is displayed by doping a blue dopant on a blue host and using Alq₃ as the electron transport layer. Alq₃ may not be formed depending on characteristic of the blue host.

A red color can be obtained by doping a red dopant instead of a green dopant in the process of manufacturing the organic electroluminescent device.

It is expected that the green luminescent device will be used practically. On the other hand, a problem arises in that the blue luminescent device does not reach its practical use in view of stability of the device, its luminous color, and its luminous efficiency.
An organic electroluminescent device according to the preamble of claim 1 is described in M. R. Robinson, S. Wang, G. C. Bazan, Y. Cao, Adv. Mater. 12 (2000) 1701-1704.

### SUMMARY OF THE INVENTION

Accordingly, the present invention is directed to an organic electroluminescent device that substantially obviates one or more problems due to limitations and disadvantages of the related art.

An object of the present invention is to provide an organic electroluminescent device that can obtain excellent luminous color and stability and can improve luminous efficiency.

Additional advantages, objects, and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, an organic electroluminescent device includes a tetraphenylmetane compound having the following compound structure as a blue electroluminescent material of an organic electroluminescent layer:

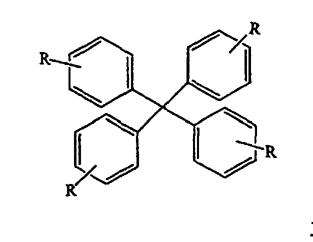

In the above compound structure, R is hydrogen(H) or 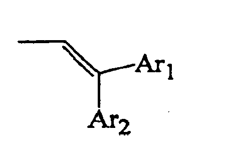 where, Ar₁ and Ar₂ are respectively independent, and are selected from a group consisting of aromatic, aliphatic, and H. Preferably, Ar₁ and Ar₂ are respectively selected from a group consisting of phenyl, naphthyl, and phenanthryl.

The organic electroluminescent device of the present invention is a blue light-emitting material of an organic luminescent body and includes the following compound structure.

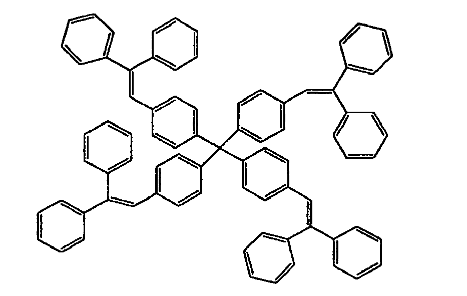

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:

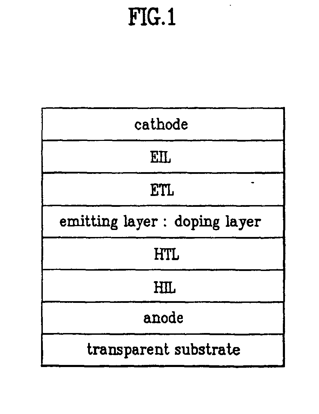

FIG. 1 is a structural sectional view illustrating an organic electroluminescent device according to the present invention; and

FIG. 2 illustrates improved luminous efficiency of an organic electroluminescent device according to the present invention.

### DETAILED DESCRIPTION OF THE INVENTION

Reference will now be made in detail to the preferred embodiments of the present invention, examples of which are illustrated in the accompanying drawings. Wherever possible, the same reference numbers will be used throughout the drawings to refer to the same or like parts.

An organic electroluminescent device according to the present invention includes a first electrode, an organic luminescent layer, and a second electrode. The organic luminescent layer includes a blue luminescent material according to claim 1.

The first electrode and the second electrode in the present invention respectively represent a hole injection electrode (anode) and an electron injection electrode (cathode). They can be used without any limitation in the field of the present invention, and are manufactured by a typical method. Also, a hole injection layer and/or a hole transport layer may be formed at both sides of the organic luminescent layer as the case may be. The hole injection layer and the hole transport layer can also be used without any limitation in the field of the present invention.

Furthermore, the organic electroluminescent device of the present invention includes a blue luminescent material of an organic luminescent layer as follows.

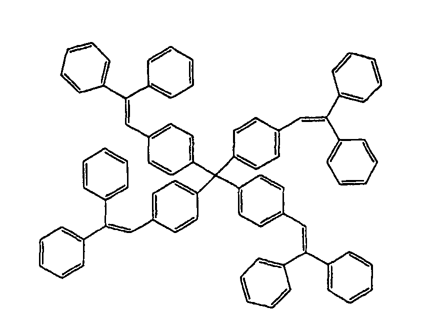

Hereinafter, examples of the present invention will be described. The following examples are exemplary and explanatory and are not intended to limit the invention.

### Examples

### (1) Synthesis of tetra-p-Bromophenylmethane

Tetraphenylmethane of 2g and FeCl₃ of 0.05g were put in a round floor flask and melted in a solvent such as CCl₄ of 50ml, and then mixed with bromine of 1.43ml. Then, the resultant product was refluxed and stirred for three days. Subsequently, the product was recrystallized in THT and methanol to obtain tetra-p-Bromophenylmethane. This can be expressed by the following chemical formula.

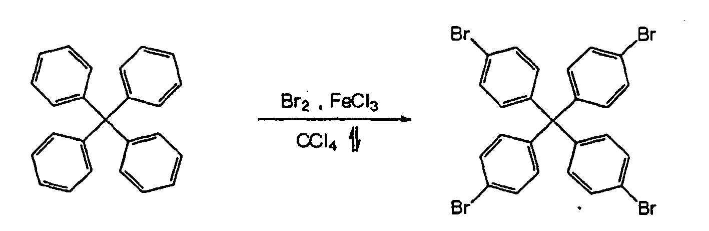

### (2) Synthesis of Biphenylboronic acid

Magnesium of 1.1g was put in a round floor flask, heated under the vacuum state for 10 minutes to completely remove moisture, and was cooled under N₂. Then, 2-Bromo-1,1-biphenylethylene of 10g melted in THT of 90ml was slowly dropped into the flask. After the drop reaction ended, the resultant product was refluxed and stirred for one hour. The product was cooled at -78°C and then trimethylborate of 5.68ml diluted in THF of 50ml was slowly dropped into the flask. The trimethylborate diluted with THF was slowly dropped into the flask. After the drop reaction ended, the resultant product was stirred at a room temperature for 12 hours. The product was then filtered so that the filtered liquid was stirred in water and 2N-HCl for 30 minutes. An organic material was separated from the product using diethylether and then concentrated. Petroleum ether was added to the concentrated organic material to extract crystal. Finally, the petroleum ether was filtered to obtain crystal of white solid. This can be expressed as follows.

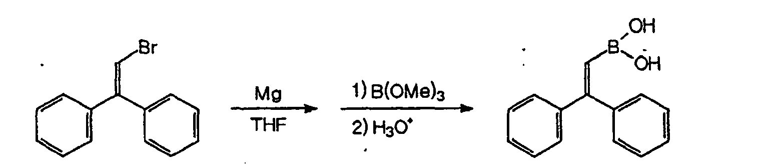

### (3) Synthesis of 3,3,3,3-tetrakis(biphenyl)methane

Tetraphenylmethane of 2g in (1), biphenylboronic acid of 6g in (2), and K₂CO₃ of 6.5g were melted in toluene of 40ml and aqua of 40ml. Then, Pd(PPh₃)₄ of 250mg was added to the resultant product obtained by melting and was refluxed and stirred for 24 hours. Subsequently, an organic material was extracted using toluene and other water fractions were three times extracted using dichlrolomethane. The organic material and the extract obtained using dichloromethane were mixed with each other and then concentrated, thereby obtaining solid. The obtained solid was recrystallized and filtered in methanol. Thus, the resultant product was washed with THF to obtain 3,3,3,3-tetrakis(biphenyl)methane which is a blue luminescent material.
This can be expressed by the following chemical formula.

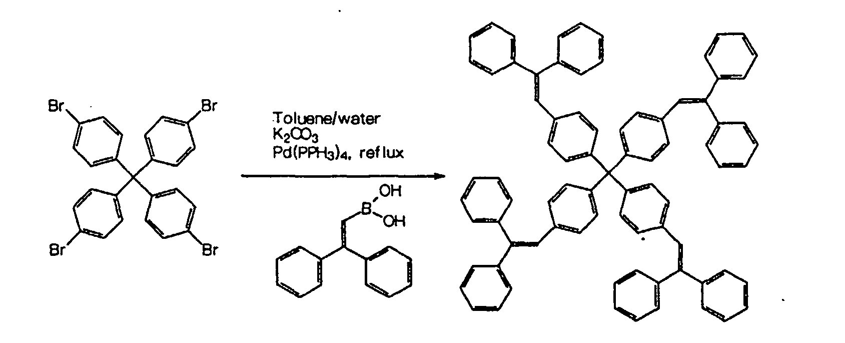

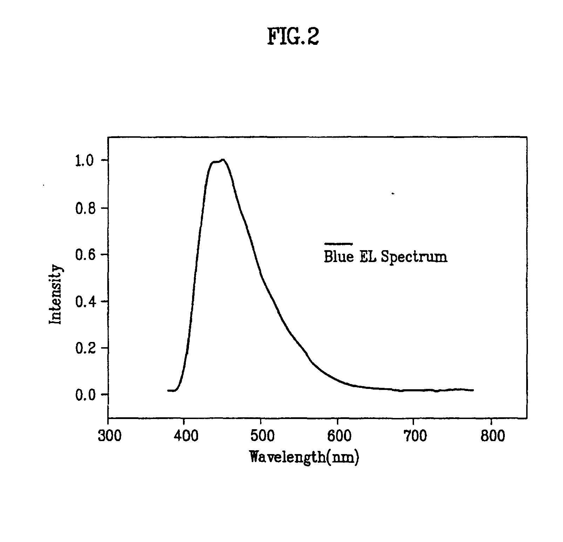

The organic electroluminescent device according to the present invention was manufactured by a typical method using the obtained blue luminescent material. That is, the organic electroluminescent device was manufactured by depositing organic materials on an indium tin oxide (ITO) glass patterned at 3mm x 3mm in the order of CuPc 25nm (250Å), NPD 35nm (350Å), BLUE 20nm (200Å), Alq₃ 40nm (400Å), LiF, and Al. At this time, the vacuum degree was 1.3x10⁻⁴ Pa (10⁻⁶torr). FIG. 2 shows EL-spectrum when current of 0.6mA flowed in the manufactured device. Also, when current of 1.6mA flowed in the device, luminance of 216nit could be obtained. In this case, efficiency was 1.22cd/A, and color coordinates were X=0.167 and Y=0.173 showing deep blue.

As described above, since the organic electroluminescent device according to the present invention includes a compound of a tetraphenylmethane structure as a blue luminescent material, excellent luminous color and stability of the device can be obtained. Also, luminous efficiency can be improved.

## Claims

1. An organic electroluminescent device comprising:
a first electrode, an organic luminescent layer, and a second electrode, the organic luminescent layer including a blue luminescent material having a tetraphenylmethane compound as follows: 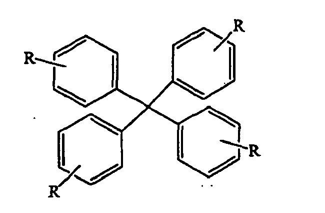 in the above compound structure, R is hydrogen(H) or 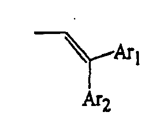 where, Ar₁ and Ar₂ are respectively independent, and are selected from a group consisting of aromatic, aliphatic, and H,
**characterized in that**
the blue luminescent material includes the following compound structure:

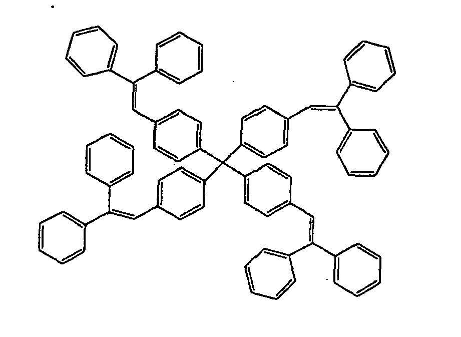

## Patentansprüche

1. Organische Elektrolumineszenzvorrichtung, Folgendes umfassend:
eine erste Elektrode, eine organische Lumineszenzschicht, und eine zweite Elektrode, wobei die organische Lumineszenzschicht ein blaues Lumineszenzmaterial mit einer Tetraphenylmethanverbindung wie folgt umfasst: 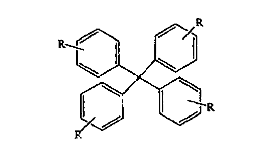
wobei in der vorstehenden Verbindungsstruktur R Wasserstoff (H) oder 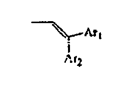 ist, worin Ar₁ und Ar₂ jeweils eigenständig und aus einer Gruppe ausgewählt sind, die aus aromatischen Substanzen, aliphatischen Substanzen und H besteht,
**dadurch gekennzeichnet, dass**
das blaue Lumineszenzmaterial die folgende Verbindungsstruktur umfasst:

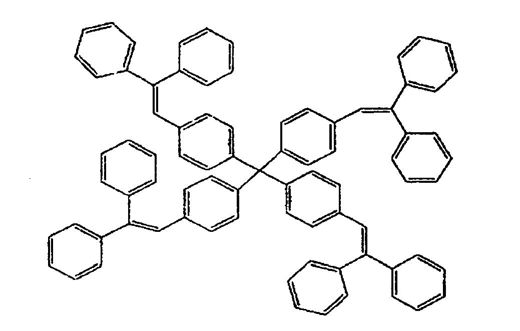

## Revendications

1. Dispositif électroluminescent organique comprenant :
une première électrode, une couche luminescente organique et une deuxième électrode, la couche luminescente organique incluant un matériau luminescent bleu comportant un composé de tétraphénylméthane comme suit : 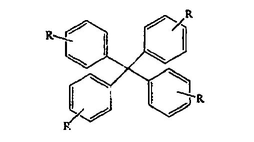
dans la structure de composé ci-dessus, R est de l'hydrogène (H) ou 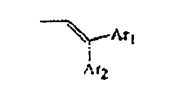 Ar₁ et Ar₂ sont respectivement indépendants et sont sélectionnés dans un groupe constitué de substances aromatiques, aliphatiques et H, où le matériau luminescent bleu comprend la structure de composé suivante :
